# DEMANDE DE BREVET EUROPEEN

(11) **EP 4 826 116 A1**
(43) Date de publication de la demande: **21.10.2026**
(21) Numéro de dépôt: 26161445.7
(22) Date de dépôt: 27.02.2026
(51) Int. Cl.: C23C 16/04, B29C 49/36, B29C 51/22, C23C 16/44, F04B 37/14, F04B 41/06, H01J 37/32, B29C 49/42, B29C 49/58, B29C 49/78, B29L 31/00

(54) **MACHINE À CARROUSEL COMPRENANT UNE PLURALITÉ DE SOURCES DE PRESSION POUR POMPER UN VOLUME À POMPER D'UN POSTE DE TRAITEMENT**

(30) Priorité: 14.03.2025 FR 2502548
(71) Demandeur: Sidel Participations, 76930 Octeville-sur-Mer (FR)
(72) Inventeur: DUCLOS, Yves-Alban, 76930 Octeville-Sur-Mer (FR); VAUDOR, Geoffroy, 76930 Octeville-Sur-Mer (FR)
(74) Mandataire: Sidel Group

(57) **Abrégé**

La machine à carrousel (1) comprend au moins un poste de traitement comprenant au moins un volume à pomper, et une pluralité de sources de pression (28), le volume à pomper étant successivement mis en communication fluidique pendant une durée prédéterminée avec chaque source de pression (28) par l'intermédiaire d'au moins une conduite associée (32) à chaque source de pression (28) et un raccord étanche tournant (14), la pression dans ledit volume à pomper étant progressivement réduite par l'établissement des communications fluidiques successives.

La durée prédéterminée de communication fluidique entre le volume à pomper et au moins une conduite associée (32) est sensiblement inférieure ou égale au temps qu'une pression d'équilibre (Pe) soit établie entre la pression dans ledit volume à pomper et la pression dans ladite conduite associée (32).

## Description

La présente invention concerne une machine à carrousel pour le traitement d'au moins un récipient, du type comprenant au moins un poste de traitement destiné à prendre en charge le récipient et comprenant au moins un volume à pomper, et une pluralité de sources de pression, le volume à pomper étant successivement mis en communication fluidique pendant une durée prédéterminée avec chaque source de pression par l'intermédiaire d'au moins une conduite associée à chaque source de pression et un raccord étanche tournant, ladite conduite associée s'étendant entre la source de pression associée et le raccord étanche tournant, la pression dans ledit volume à pomper étant progressivement réduite par l'établissement des communications fluidiques successives entre ledit volume à pomper et lesdites conduites associées aux sources de pression.

L'invention concerne également un procédé d'établissement d'un vide dans un récipient à traiter au moyen d'une telle machine à carrousel.

Le document WO 00/58631 décrit une machine à carrousel dans laquelle un volume à pomper d'un récipient pris en charge par la machine à carrousel est placé en communication fluidique avec plusieurs sources de pression afin de réduire la pression dans le récipient en vue d'appliquer un traitement dans ledit récipient. Ce traitement est plus particulièrement l'application d'un revêtement à l'intérieur du récipient au moyen d'un plasma basse pression. Un tel traitement nécessite l'établissement d'une pression proche du vide à l'intérieur du récipient et, pour ce faire, le volume à pomper à l'intérieur du récipient est mis en communication fluidique successivement avec plusieurs sources de pression afin de réduire progressivement la pression dans le récipient avec chaque mise en communication fluidique. Chaque mise en communication fluidique est mise en œuvre pendant le temps nécessaire à la source de pression pour pomper sensiblement tout le volume qu'elle est capable de pomper avant de passer à une autre source de pression présentant un débit volumique plus important.

Bien que la machine à carrousel décrite dans ce document permette d'établir rapidement un vide dans un récipient à un coût raisonnable, on cherche toujours à obtenir une cadence de traitement plus importante, notamment en accélérant l'établissement du vide dans le récipient sans augmenter les coûts liés à cette étape.

L'un des buts de l'invention est de répondre à ces exigences en proposant une machine à carrousel permettant de réduire la pression dans un volume à pomper en un temps réduit.

A cet effet, l'invention concerne une machine à carrousel du type précité, dans laquelle la durée prédéterminée de communication fluidique entre le volume à pomper et au moins une conduite associée à une des sources de pression est sensiblement inférieure ou égale au temps qu'une pression d'équilibre soit établie entre la pression dans ledit volume à pomper et la pression dans ladite conduite associée.

En limitant la durée prédéterminée pendant laquelle le volume à pomper est mis en communication fluidique avec la conduite associée à une des sources de pression à une durée inférieure ou égale au temps nécessaire à l'établissement d'une pression d'équilibre entre le volume à pomper et la conduite associée, on réduit cette durée prédéterminée à une période pendant laquelle la réduction de la pression dans le volume à pomper se fait à une vitesse particulièrement importante sans attendre la phase suivante après l'établissement de la pression d'équilibre dans laquelle la réduction de pression se fait à un rythme de moins en moins soutenu. En plaçant le volume à pomper en communication fluidique avec la source de pression suivante à l'issue de cette durée prédéterminée, on accélère fortement la cadence à laquelle la pression dans le récipient est réduite sans pour autant augmenter les coûts en augmentant la capacité de pompage des sources de pression par exemple.

La machine à carrousel selon l'invention peut en outre comprendre une ou plusieurs des caractéristiques suivantes, considérées seules ou selon toute combinaison techniquement envisageable :
- la machine à carrousel comprend une roue entrainant le poste de traitement en rotation de sorte à placer successivement le volume à pomper avec chaque conduite associée à chaque source de pression sur un secteur angulaire associé à chaque conduite associée, au moins un des secteurs angulaires présentant une dimension angulaire telle que le volume à pomper est placé en communication fluidique avec la conduite associée pendant la durée prédéterminée lorsque le poste de traitement circule dans ledit secteur angulaire ;
- la mise en communication successive entre le volume à pomper et chaque conduite associée est réalisée par une pluralité de vannes ;
- le poste de traitement comprend deux volumes à pomper isolés l'un de l'autre, chacun desdits volumes à pomper étant successivement mis en communication fluidique pendant une durée prédéterminée avec une conduite associée avec chaque source de pression, la pression dans lesdits volumes à pomper étant progressivement réduite par l'établissement des communications fluidiques successives entre lesdits volumes à pomper et lesdites conduites associées ;
- les mises en communication fluidique successives entre les volumes à pomper et les conduites associées sont agencées pour que les pressions dans les volumes à pomper soient réduites en maintenant un écart inférieur à un seuil prédéterminé entre lesdites pressions ;
- le poste de traitement comprend une enceinte recevant le récipient pris en charge par ledit poste de traitement, l'un des volumes à pomper étant formé par le volume interne du récipient placé dans l'enceinte et par le volume d'une conduite embarquée s'étendant entre le volume interne et le raccord étanche tournant et l'autre volume à pomper étant formé par le volume interne de l'enceinte autour du récipient placé dans l'enceinte et par le volume d'une conduite embarquée s'étendant entre le volume interne de l'enceinte et le raccord étanche tournant ;
- la pluralité de sources de pression comprend au moins un premier groupe de pompage comprenant au moins une pompe et un deuxième groupe de pompage comprenant au moins une pompe, le volume à pomper étant mis en communication fluidique avec le premier groupe de pompage puis avec le deuxième groupe de pompage, la pompe du premier groupe de pompage présentant un débit volumique inférieur au débit volumique de la pompe du deuxième groupe de pompage ;
- la machine à carrousel comprend une pluralité de postes de traitement comprenant chacun au moins un volume à pomper, lesdits volumes à pomper étant successivement mis en communication fluidique pendant une durée prédéterminée avec chaque source de pression les uns après les autres ;
- le volume à pomper est mis simultanément en communication fluidique pendant un instant prédéterminé avec deux sources de pression, ledit instant prédéterminé étant inférieur à la durée prédéterminée inférieure ou égale au temps qu'une pression d'équilibre soit établie entre la pression dans ledit volume à pomper et la pression dans la conduite associée à l'une des deux sources de pression ;
- au moins une des sources de pression est associée à deux conduites associées entre ladite source de pression et le raccord étanche tournant, la pression dans lesdites conduites associées étant différente l'une de l'autre avant la mise en communication fluidique de chacune desdites conduites associées avec le volume à pomper.

Selon un autre aspect, l'invention concerne également un procédé d'établissement d'un vide dans un récipient à traiter au moyen d'une machine à carrousel telle que décrite ci-dessus, comprenant au moins les étapes suivantes :
- placer le récipient dans un poste de traitement de la machine à carrousel, le volume interne du récipient et le volume d'une conduite embarquée s'étendant entre le volume interne et le raccord étanche tournant formant un volume à pomper dudit poste de traitement,
- placer ledit volume à pomper en communication fluidique avec une conduite associée à une première source de pression de la pluralité de sources de pression pendant une première durée prédéterminée inférieure ou égale au temps qu'une pression d'équilibre soit établie entre la pression dans ledit volume à pomper et la pression dans ladite conduite associée, la pression dans le volume à pomper diminuant jusqu'à une première pression réduite pendant ladite première durée prédéterminée,
- placer le volume à pomper à la première pression réduite en communication fluidique avec une conduite associée à une deuxième source de pression de la pluralité de sources de pression pendant une deuxième durée prédéterminée, la pression dans le volume à pomper diminuant de la première pression réduite à une deuxième pression réduite, inférieure à la première pression réduite pendant ladite deuxième durée prédéterminée.

Le procédé d'établissement d'un vide selon l'invention peut comprendre un ou plusieurs des caractéristiques suivantes, considérées seules ou en combinaison :
- la pression dans le volume à pomper est réduite jusqu'à une pression inférieure ou égale à 0.3 mbar en plaçant ledit volume à pomper successivement en communication fluidique avec au moins une conduite associée à chaque source de pression de la pluralité de sources de pression ;
- le récipient est placé dans une enceinte du poste de traitement, le volume interne du récipient et le volume de la conduite embarquée formant un premier volume à pomper dudit poste de traitement et le volume interne de l'enceinte autour du récipient et le volume d'une conduite embarquée s'étendant entre le volume interne de l'enceinte et le raccord étanche tournant formant un deuxième volume à pomper dudit poste de traitement, ledit deuxième volume à pomper étant mis en communication fluidique avec une source de pression de la pluralité de sources de pression avant ou simultanément avec le placement du premier volume à pomper en communication fluidique avec ladite source de pression.

D'autres aspects et avantages de l'invention apparaîtront plus clairement à la lecture de la description qui va suivre, donnée uniquement à titre d'exemple non limitatif, et faite en référence aux dessins annexés, dans lesquels :
[Fig.1] - la [Fig.1] est une représentation schématique d'une machine à carrousel selon un mode de réalisation de l'invention,
[Fig.2] - la [Fig.2] est une représentation schématique du principe de mise en communication fluidique entre un poste de traitement et une source de pression pour la mise en œuvre de l'invention,
[Fig.3] - la [Fig.3] est une représentation schématique d'une partie de la machine à carrousel de la [Fig.1], et
[Fig.4] - la [Fig.4] est un ensemble de graphiques mettant en relation le pilotage de la machine à carrousel selon l'invention et la pression dans un volume à pomper et dans une canalisation associée à une source de pression.

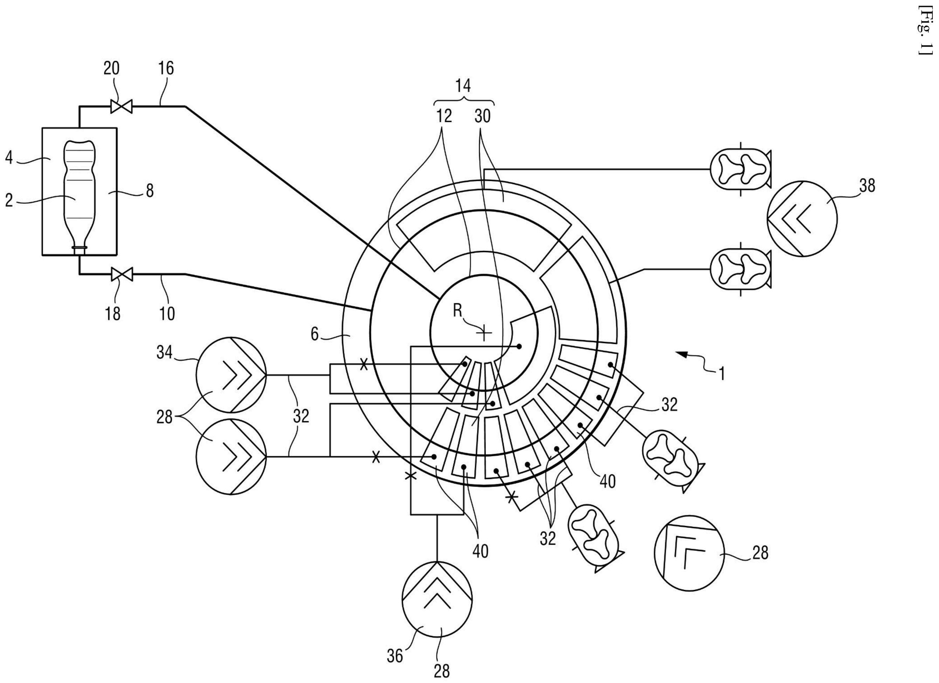

En référence à la [Fig.1], on décrit une machine à carrousel 1 pour le traitement d'au moins un récipient 2.

Un tel récipient 2 est par exemple une bouteille ou un flacon en matière synthétique et à l'intérieur duquel on souhaite appliquer un revêtement, par exemple au moyen d'un plasma basse pression. Un tel revêtement est plus particulièrement prévu pour conférer un effet barrière au récipient afin d'améliorer l'imperméabilité au gaz du récipient. Un tel traitement du récipient 2 est par exemple divulgué dans le document WO 99/49991 et l'homme du métier pourra se référer à celui-ci pour avoir plus d'informations sur la mise en œuvre d'un plasma.

La machine à carrousel 1 comprend au moins un poste de traitement 4 agencé pour recevoir le récipient 2. Le poste de traitement 4 par exemple porté par une roue 6, ou carrousel, mobile en rotation atour d'un axe de rotation R. De façon classique, la roue 6 porte plusieurs postes de traitement 4 agencés pour recevoir chacun un récipient 2 de sorte que le traitement peut se faire sur une succession de récipients 2 les uns à la suite des autres.

Le ou chaque poste de traitement 4 comprend une enceinte 8 agencée pour recevoir le récipient 2. Le poste de traitement 4 définit au moins un volume à pomper, par exemple formé par le volume interne du récipient 2, lorsqu'il est reçu dans l'enceinte 8, et par le volume d'une conduite embarquée 10 s'étendant entre le volume interne du récipient 2 et la partie mobile 12 d'un raccord étanche tournant 14, décrit plus en détail ultérieurement. Selon un mode de réalisation, ce volume à pomper est un premier volume à pomper du poste de traitement 4 et le poste de traitement 4 définit un deuxième volume à pomper, formé par le volume interne de l'enceinte 8 autour du récipient 2 et par le volume d'une conduite embarquée 16 s'étendant entre le volume interne de l'enceinte 8 et la partie mobile 12 du raccord étanche tournant 14. Dans ce cas, le premier volume à pomper et le deuxième volume à pomper sont isolés l'un de l'autre.

Le ou chaque poste de traitement 4 comprend par exemple en outre au moins une vanne 18 agencée entre le récipient 2 et la conduite embarquée 10 pour bloquer ou autoriser la communication fluidique entre le volume interne du récipient 2 et cette conduite embarquée. Le cas échéant, le ou chaque poste de traitement 4 comprend par exemple en outre au moins une vanne 20 agencée entre l'enceinte 8 et la conduite embarquée 16 pour bloquer ou autoriser la communication fluidique entre le volume interne de l'enceinte 8 et cette conduite embarquée 16.

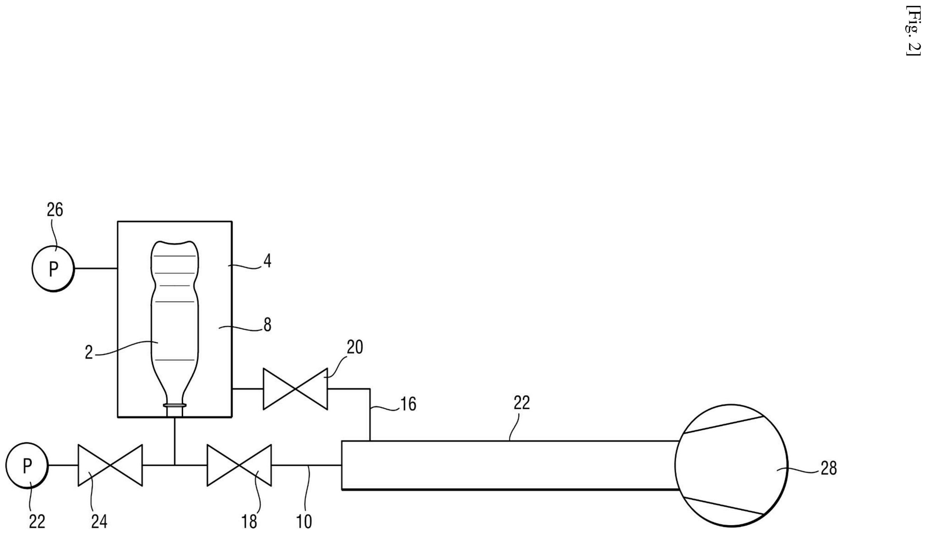

Comme représenté sur la [Fig.2], le poste de traitement 4 peut également comprendre un capteur de pression 22 de la pression dans le volume interne du récipient 2 avec une vanne 24 interposée entre ce capteur de pression 22 et le volume interne du récipient et/ou un capteur de pression 26 de la pression dans le volume interne de l'enceinte 8.

La machine à carrousel 1 comprend en outre une pluralité de sources de pression 28 permettant de pomper le ou les volumes à pomper du ou de chaque poste de traitement 4, comme cela sera décrit plus en détail ultérieurement. Chaque source de pression 28 est raccordée à une partie fixe 30 du raccord étanche tournant 14 par au moins une conduite associée 32 à la source de pression 28.

De façon connue, le raccord étanche tournant 14 permet de mettre en communication fluidique les conduites embarquées 10, 16 du ou des postes de traitement 4 avec les conduites associées 32 des sources de pression 28 et ainsi de mettre en communication fluidique les volumes à pomper avec les sources de pression 28. En d'autres termes, le raccord étanche tournant 14 permet d'établir des communications fluidiques étanches entre des parties mobiles, à savoir les postes de traitement 4, et des parties fixes, à savoir les sources de pression 28, de la machine à carrousel 1. Plus particulièrement, le raccord étanche tournant 14 permet de placer un poste de traitement 4 en communication fluidique successivement avec toutes les sources de pression 28 au fur et à mesure que le poste de traitement 4 est déplacé en rotation par la roue 6. Le principe d'un tel raccord étanche tournant 14 et de la mise en communication fluidique successive entre un poste de traitement 4 et plusieurs sources de pression 28 est décrit dans le document WO 00/58631 et l'homme du métier pourra se référer à ce document pour avoir plus de détails sur ce principe.

La pluralité de sources de pression 28 comprend par exemple au moins un premier groupe de pompage 34 comprenant au moins une pompe et un deuxième groupe de pompage 36 comprenant au moins une pompe. Selon un mode de réalisation et comme représenté sur la [Fig.1], la pluralité de sources de pression 28 comprend plus de deux groupes de pompage, chaque groupe de pompage comprenant au moins une pompe. Lorsqu'un poste de traitement 4 recevant un récipient 2 est déplacé en rotation par la roue 6, le ou les volumes à pomper du poste de traitement 4 sont ainsi successivement mis en communication fluidique avec le premier groupe de pompage 34 puis avec le deuxième groupe de pompage 36, puis éventuellement avec le ou les groupes de pompage suivants.

Au moins les premier et deuxième groupes de pompage 34, 36 sont agencés pour réduire la pression dans le ou les volumes à pomper du poste de traitement 4 lorsque ces volumes de pompage sont en communication fluidique respectivement avec le premier groupe de pompage 34 et avec le deuxième groupe de pompage 36. En d'autres termes, lors de ces communications fluidiques, la ou les pompes du premier et du deuxième groupes de pompage 34, 36 pompent l'air dans le ou les volumes à pomper du poste de traitement afin de réduire la pression dans ces volumes.

Ainsi, le premier groupe de pompage 34 est agencé pour réduire la pression dans le ou les volumes à pomper d'une pression initiale, par exemple égale à la pression atmosphérique, à une première pression réduite, inférieure à la pression initiale. Le deuxième groupe de pompage 36 est quant à lui agencé pour réduire la pression de la première pression réduite à une deuxième pression réduite, inférieure à la première pression réduite.

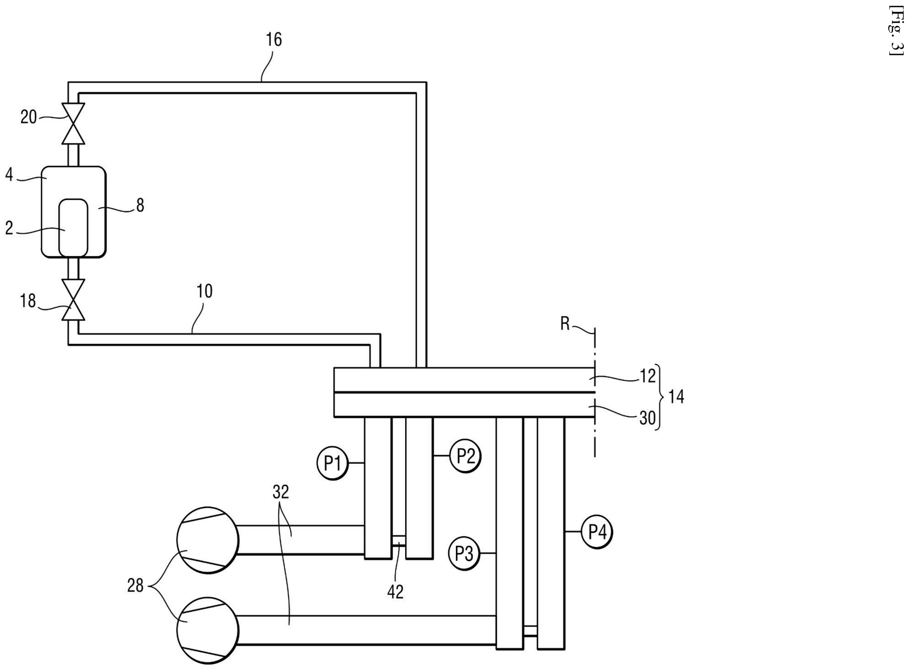

Selon un mode de réalisation, au moins l'un des groupes de pompage comprend une pompe et au moins une conduite associée 32 mise en communication fluidique avec le premier volume à pomper afin de réduire la pression dans le premier volume à pomper et une autre pompe et au moins une conduite associée 32 mise en communication fluidique avec le deuxième volume à pomper, comme représenté sur la [Fig.3]. En variante ou en complément, une même pompe est associée à une conduite associée 32 mise en communication fluidique avec le premier volume à pomper et à une autre conduite associée 32 mise en communication fluidique avec le deuxième volume à pomper, comme représenté sur la [Fig.3].

Dans la mesure où plus la pression dans un volume à pomper est faible, plus cette pression est difficile à faire descendre encore, la pompe ou les pompes du deuxième groupe de pompage 36 présentent avantageusement un débit volumique supérieur à celui du premier groupe de pompage 34. Un tel agencement par groupes de pompage avec des débits volumiques croissants permet notamment de réduire les coûts liés à la puissance de pompage nécessaire pour faire baisser la pression dans les volumes à pomper, notamment jusqu'à une pression proche du vide. En effet, avec un tel agencement, une ou plusieurs pompes présentant un débit volumique relativement faible peuvent être utilisées dans une phase où la réduction de la pression ne nécessite pas une puissance de pompage importante, comme cela est le cas pour passer de la pression initiale à la première pression réduite et une ou plusieurs pompes présentant un débit volumique relativement important peuvent être utilisées dans une phase où la réduction de pression nécessite une puissance de pompage importante, comme cela est le cas pour passer de la première pression réduite à la deuxième pression réduite.

Selon cet agencement, lorsque plus de deux groupes de pompage sont prévus, les groupes de pompage agencés après le deuxième groupe de pompage présentent des débits volumiques croissants. Le nombre de groupes de pompage est choisi pour que la pression dans le récipient soit réduite jusqu'à une pression proche du vide, par exemple inférieure à 0.3 mbar, en faisant un compromis entre la place disponible pour établir les communications fluidiques entre le poste de traitement 4 et les groupes de pompage lors de la rotation du poste de traitement 4 avec la roue 6 et l'augmentation progressive des débits volumiques nécessaires pour atteindre la pression souhaitée dans le récipient 2.

Selon un mode de réalisation, la machine à carrousel 1 comprend au moins un groupe de pompage de maintien 38 de la pression dans le récipient 2 une fois que la pression souhaitée a été atteinte, c'est-à-dire que ce groupe de pompage de maintien 38 ne fait pas plus baisser la pression dans le ou les volumes à pomper mais maintien celle-ci à la ou aux pressions souhaitées. Un tel groupe de pompage de maintien 38 est alors agencé pour être le dernier groupe de pompage avec lequel le poste de traitement est mis en communication fluidique. De plus, c'est pendant cette mise en communication fluidique avec le groupe de pompage de maintien 38 que le traitement est effectué sur le récipient 2 reçu dans le poste de traitement 4 de sorte que ce traitement est effectué à basse pression.

Comme indiqué précédemment, la pression dans le récipient 2 est réduite par les groupes de pompage successifs jusqu'à atteindre une pression proche du vide, par exemple inférieure à 0.3 mbar, plus particulièrement comprise entre 0.02 mbar et 0.3 mbar, par exemple sensiblement égale à 0.1 mbar.

En outre, afin d'éviter une déformation du récipient 2 sous l'effet de la dépression à l'intérieur de celui-ci, la pression dans le volume interne de l'enceinte 8, c'est-à-dire dans le deuxième volume à pomper, est réduite progressivement avec celle dans le récipient 2, c'est-à-dire dans le premier volume à pomper. En d'autres termes, les mises en communication fluidique successives entre les volumes à pomper et les conduites associées aux sources de pression 28 sont agencées pour que les pressions dans les volumes à pomper, c'est-à-dire dans le premier volume à pomper et dans le deuxième volume à pomper, soient réduites en maintenant un écart inférieur à un seuil prédéterminé entre lesdites pressions. Plus particulièrement, les réductions de pression progressives dans le premier volume à pomper et dans le deuxième volume à pomper sont agencées pour que l'écart de pression entre le premier volume à pomper et le deuxième volume à pomper soit inférieur ou égal à 100 mbar, plus particulièrement sensiblement égal à 50 mbar. Cet écart de pression est tel que la pression dans le deuxième volume à pomper est supérieur à la pression dans le premier volume à pomper.

La mise en communication fluidique entre un volume à pomper et une conduite associée 32 à une source de pression 28 se fait pendant une durée prédéterminée correspondant au temps nécessaire pour que la pression dans le volume à pomper soit réduite jusqu'à la pression souhaitée à l'issue de cette mise en communication fluidique. Ainsi, pour le premier groupe de pompage 34, la durée prédéterminée de la mise en communication fluidique entre le premier volume à pomper et au moins une conduite associée 32 au premier groupe de pompage correspond au temps nécessaire pour passer de la pression initiale à la première pression réduite. Comme la mise en communication fluidique se fait alors que le poste de traitement 4 se déplace en rotation avec la roue 6, la durée prédéterminée correspond ainsi à un secteur angulaire 40 de la rotation de la roue 6. Ainsi, en ajustant le secteur angulaire sur lequel la communication fluidique est établie entre un volume à pomper et une conduite associée 32 à une source de pression 28 sur le principe décrit par exemple dans le document WO 00/58631, la durée prédéterminée peut être réglée, notamment en tenant compte du débit volumique de la pompe raccordée à la conduite associée.

En variante, les communications fluidiques successives de durée prédéterminée sont réalisées par des vannes successives au lieu de secteurs angulaires tels que décrits dans le document susmentionné.

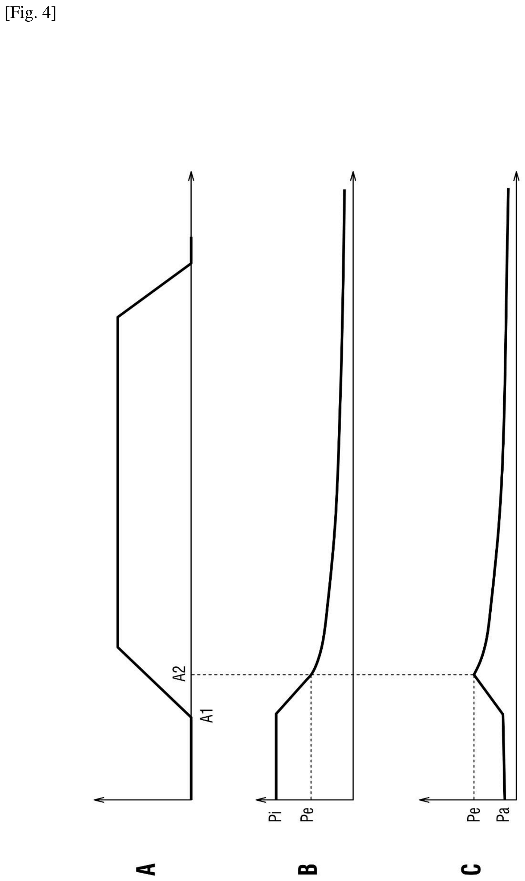

En référence à la [Fig.4], le choix d'une durée prédéterminée adaptée pour une réduction rapide de la pression dans le ou les volumes à pomper, notamment au niveau du premier groupe de pompage 34, va à présent être décrit. Sur la [Fig.4], il est représenté sur le graphique A, la commande de l'établissement de la communication fluidique entre un volume à pomper et une conduite associée 32 à une source de pression 28 en fonction du temps. Sur le graphique B, il est représenté la pression dans ce volume à pomper et sur le graphique C la pression dans cette conduite associée.

Lorsque le poste de traitement 4 entre dans le secteur angulaire 40 correspondant, la mise en communication fluidique commence au point A1 du graphique A alors que la pression dans le volume à pomper est égale à une pression initiale Pi (graphique B) et la pression dans la conduite associée est égale à une pression d'aspiration Pa (graphique C). La pression d'aspiration Pa dans la conduite associée est due à l'action de la source de pression 28 qui aspire l'air dans la conduite associée 32.

Lorsque la communication fluidique entre le volume à pomper et la conduite associée 32 est établie au point A1, la source de pression 28 aspire l'air dans le volume à pomper par l'intermédiaire de la conduite associée 32, ce qui entraîne une baisse de la pression dans le volume à pomper et une augmentation de la pression dans la conduite associée jusqu'à ce qu'une pression d'équilibre Pe soit atteinte dans le volume à pomper et dans la conduite associée 32 au point A2. Comme on peut le constater sur le graphique B, la diminution de la pression dans le volume à pomper de la pression initiale Pi à la pression d'équilibre Pe entre les points A1 et A2 se fait de façon particulièrement rapide.

Lorsque la communication fluidique est maintenue au-delà du point A2, on constate que la pression dans le volume à pomper continue à descendre alors que la pression dans la conduite associée redescend vers la pression d'aspiration Pa. Cependant, comme visible sur les graphiques B et C, cette baisse de la pression se fait beaucoup moins rapidement.

Ainsi, selon l'invention, la durée prédéterminée pendant laquelle le volume à pomper est mis en communication fluidique avec la conduite associée 32 (et donc la dimension angulaire du secteur angulaire 40 correspondant) est choisie pour être inférieure ou égale au temps nécessaire pour l'établissement de la pression d'équilibre Pe entre la pression dans le volume à pomper et la pression dans la conduite associée 32. En d'autres termes, en se référant aux graphiques de la [Fig.4], la durée prédéterminée est choisie entre les points A1 et A2 du graphique A, ce qui correspond à la phase pendant laquelle la pression diminue rapidement dans le volume à pomper. De préférence, la durée prédéterminée est choisie pour être le plus proche possible du temps nécessaire pour l'établissement de la pression d'équilibre Pe, c'est-à-dire le plus proche possible du point A2. En d'autres termes, la communication fluidique n'est établie uniquement au cours de la phase de baisse rapide de la pression dans le volume à pomper et pas au-delà.

Ce même principe est par exemple appliqué pour la mise en communication fluidique entre le deuxième volume à pomper et une conduite associée 32 du premier groupe de pompage 34.

Selon un mode de réalisation, ce principe est également appliqué à la durée prédéterminée pendant laquelle le ou les volumes à pomper sont mis en communication fluidique avec la ou les conduites associées 32 du deuxième groupe de pompage et/ou des groupes de pompage supplémentaires en dehors du ou des groupes de pompage de maintien 38.

Il est ainsi possible de faire descendre la pression dans le ou les volumes à pomper de façon particulièrement rapide en limitant au moins certaines de communication fluidiques établies entre un volume à pomper et une source de pression 28 à une durée pendant laquelle la baisse de pression dans le volume à pomper se fait dans la phase rapide avant ou jusqu'à l'établissement de la pression d'équilibre entre le volume à pomper et la conduite associée 32.

Selon un mode de réalisation permettant encore d'accélérer la baisse de la pression dans le volume à pomper, le volume à pomper est mis en communication fluidique simultanée pendant un instant prédéterminé avec deux sources de pression 28 adjacentes. Cet instant prédéterminé est inférieur à la durée prédéterminée inférieure ou égale au temps qu'une pression d'équilibre soit établie entre la pression dans le volume à pomper et la pression dans la conduite associée 32 à l'une des deux sources de pression 28. En d'autres termes, le volume à pomper est mis en communication fluidique avec une source de pression 28 alors que la pression dans le volume à pomper n'a pas encore atteint la pression d'équilibre avec la pression dans la conduite associée 32 à l'autre source de pression 28. Ainsi, la mise en communication fluidique simultanée avec les deux sources de pression 28 successives se fait dans la phase de baisse rapide de la pression dans le volume à pomper aussi bien avec l'une des conduites associées 32 qu'avec l'autre conduite associée 32 à ces deux sources de pression 28.

Selon un mode de réalisation représenté sur la [Fig.3] permettant de réduire encore les coûts liés à la puissance de pompage nécessaire pour atteindre la pression réduite dans le volume à pomper, au moins une source de pression 28 est associée à deux conduites associées 32 entre la source de pression et le raccord tournant 14 pour une mise en communication fluidique successive avec le même volume à pomper. La pression dans ces conduites associées est différente l'une de l'autre avant la mise en communication fluidique de chacune de ces conduites associées 32 avec le volume à pomper. En d'autres termes, la pression d'aspiration Pa dans l'une de ces conduites associées 32 est supérieure à la pression d'aspiration Pa dans l'autre de ces conduites associées 32. Le volume à pomper est alors d'abord mis en communication fluidique avec la conduite associée 32 dans laquelle la pression d'aspiration est supérieure puis avec l'autre conduite associée 32 dans laquelle la pression d'aspiration est inférieure. Ces mises en communication fluidique successives permettent alors de reproduire le fonctionnement décrit précédemment avec des pompes présentant successivement des débits volumiques croissants. Afin que l'une des conduites associées 32 présente une pression d'aspiration supérieure à celle de l'autre conduite associée 32, la section de l'une des conduites est par exemple inférieure à celle de l'autre conduite et/ou un élément de restriction 42 est agencé entre les deux conduites associées 32. Un tel élément de restriction 42 forme un goulot d'étranglement augmentant mécaniquement la pression dans la conduite associée en communication fluidique avec la source de pression par l'intermédiaire de cet élément de restriction 42. Ainsi, avec une même source de pression 28, il est possible de réduire progressivement la pression dans un volume à pomper à une première pression réduite grâce à l'une des conduites associées 32 puis de passer de la première pression réduite à une deuxième pression réduite inférieure grâce à l'autre conduite associée 32.

Le fonctionnement de la machine à carrousel 1 pour réduire la pression dans un récipient 2 va à présent être décrit. Toutes les étapes de ce fonctionnement se font alors que le poste de traitement est entraîné en rotation avec la roue 6.

Le récipient 2 est tout d'abord placé dans un poste de traitement 4 et son volume interne est mis en communication fluidique avec la conduite embarquée 10 de ce poste de traitement par l'ouverture de la vanne 18 correspondante afin de former le premier volume à pomper. Le cas échéant, le deuxième volume à pomper est également formé par la mise en communication fluidique du volume interne de l'enceinte 8 autour du récipient 2 avec la conduite embarquée 16 correspondante par l'ouverture de la vanne 20.

Le poste de traitement atteint alors le secteur angulaire dans lequel le premier volume à pomper est mis en communication fluidique avec une conduite associée 32 du premier groupe de pompage 34. La pression dans le premier volume à pomper est alors réduite d'une pression initiale Pi à une première pression réduite supérieure ou égale à la pression d'équilibre Pe entre le premier volume à pomper et cette conduite associée 32 car la durée prédéterminée de cette mise en communication fluidique est inférieure ou égale au temps nécessaire pour l'établissement de la pression d'équilibre Pe entre la pression dans le premier volume à pomper et la pression dans cette conduite associée 32, comme décrit précédemment.

Simultanément ou avant cette mise en communication fluidique du premier volume à pomper, le deuxième volume à pomper est mis en communication fluidique avec une conduite associée 32 au premier groupe de pompage 34, par exemple avec une autre pompe de ce premier groupe de pompage 34, afin de réduire la pression dans le deuxième volume à pomper de sorte que l'écart de pression entre le premier volume à pomper et le deuxième volume à pomper soit maintenu inférieur à un seuil prédéterminé entre lesdites pressions, comme décrit précédemment. Le fait de mettre le deuxième volume à pomper en communication fluidique avec la conduite associée 32 correspondante avant ou simultanément de la mise en communication fluidique du premier volume à pomper avec la conduite associée 32 correspondante se fait en décalant les secteurs angulaires 40 correspondant ou en les confondant. Ainsi, sur l'exemple de la [Fig.1], dans lequel les secteurs angulaires 40 de mise en communication fluidique du deuxième volume à pomper avec les groupes de pompage sont décalés par rapport aux secteurs angulaires 40 de mise en communication fluidique du premier volume à pomper avec les groupes de pompage, la pression dans le deuxième volume à pomper est réduite avant la réduction de la pression dans le premier volume à pomper.

Une fois que la première pression réduite est atteinte dans le premier volume à pomper est atteinte, le premier volume à pomper est mis en communication fluidique avec la conduite associée 32 à la source de pression 28 suivante, par exemple dans le deuxième groupe de pompage 36. Cette mise en communication fluidique peut se faire selon le même principe que celle décrite précédemment, c'est-à-dire avec une durée prédéterminée inférieure ou égale au temps nécessaire pour l'établissement d'une pression d'équilibre entre la pression dans le premier volume à pomper et la pression dans cette conduite associée 32. En variante, cette nouvelle mise en communication fluidique se fait pendant une durée prédéterminée supérieure, c'est-à-dire après que la pression d'équilibre Pe a été atteinte. En effet, pour des raisons d'encombrement ou lorsqu'il n'est pas justifié d'ajouter d'autres sources de pression pour atteindre la pression souhaitée dans le premier volume à pomper, il peut être préférable et plus rapide de maintenir la communication fluidique jusqu'à ce que la pression souhaitée soit atteinte dans le premier volume à pomper après le passage à la pression d'équilibre plutôt que de prévoir une mise en communication fluidique avec une source de pression supplémentaire.

Quel que soit le mode de réalisation, la pression dans le premier volume à pomper est égale à la deuxième pression réduite à l'issue de cette nouvelle mise en communication fluidique. Le même principe est mis en œuvre pour le deuxième volume à pomper afin de maintenir l'écart entre le premier volume à pomper et le deuxième volume à pomper, comme décrit précédemment.

Si la deuxième pression réduite est égale à la pression souhaitée proche du vide dans le premier volume à pomper, le premier volume à pomper est ensuite mis en communication fluidique avec le groupe de pompage de maintien 38 et le traitement à basse pression, tel que la mise en œuvre d'un plasma à basse pression, est réalisé sur le récipient 2.

Si la deuxième pression réduite est supérieure à la pression souhaitée, un ou plusieurs groupes de pompage supplémentaires sont prévus pour réduire la pression dans le premier volume à pomper et dans le deuxième volume à pomper comme décrit précédemment jusqu'à ce que la pression souhaitée soit atteinte avec de passer au groupe de pompage de maintien 38.

Lorsque la machine à carrousel 1 comprend plusieurs postes de traitement, les étapes décrites ci-dessus sont mises en œuvre successivement sur les postes de traitement 4, un poste de traitement étant par exemple en communication fluidique avec le deuxième groupe de pompage 36 pendant le poste de traitement suivant est en communication fluidique avec le premier groupe de pompage 34.

La machine à carrousel 1 décrite ci-dessus et le procédé d'établissement d'un vide dans un récipient mettant en œuvre cette machine à carrousel permettent d'atteindre rapidement une pression proche d'un vide à l'intérieur du récipient 2 tout en minimisant les coûts liés à la puissance de pompage nécessaire à l'atteinte de cette pression, notamment en optimisant le temps de mise en communication fluidique entre les volumes à pomper et une ou plusieurs conduites associées 32 aux sources de pression 28 de la machine à carrousel 1.

## Revendications

1. Machine à carrousel (1) pour le traitement d'au moins un récipient (2), comprenant au moins un poste de traitement (4) destiné à prendre en charge le récipient (2) et comprenant au moins un volume à pomper, et une pluralité de sources de pression (28), le volume à pomper étant successivement mis en communication fluidique pendant une durée prédéterminée avec chaque source de pression (28) par l'intermédiaire d'au moins une conduite associée (32) à chaque source de pression (28) et un raccord étanche tournant (14), ladite conduite associée (32) s'étendant entre la source de pression (28) associée et le raccord étanche tournant (14), la pression dans ledit volume à pomper étant progressivement réduite par l'établissement des communications fluidiques successives entre ledit volume à pomper et lesdites conduites associées (32) aux sources de pression (28), **caractérisée en ce que** la durée prédéterminée de communication fluidique entre le volume à pomper et au moins une conduite associée (32) à une des sources de pression (28) est sensiblement inférieure ou égale au temps qu'une pression d'équilibre (Pe) soit établie entre la pression dans ledit volume à pomper et la pression dans ladite conduite associée (32).

2. Machine à carrousel selon la revendication 1, comprenant une roue (6) entrainant le poste de traitement (4) en rotation de sorte à placer successivement le volume à pomper avec chaque conduite associée (32) à chaque source de pression (28) sur un secteur angulaire (40) associé à chaque conduite associée (32), au moins un des secteurs angulaires (40) présentant une dimension angulaire telle que le volume à pomper est placé en communication fluidique avec la conduite associée (32) pendant la durée prédéterminée lorsque le poste de traitement (4) circule dans ledit secteur angulaire (40).

3. Machine à carrousel selon la revendication 1, dans laquelle la mise en communication successive entre le volume à pomper et chaque conduite associée (32) est réalisée par une pluralité de vannes.

4. Machine à carrousel selon l'une quelconque des revendications 1 à 3, dans laquelle le poste de traitement (4) comprend deux volumes à pomper isolés l'un de l'autre, chacun desdits volumes à pomper étant successivement mis en communication fluidique pendant une durée prédéterminée avec une conduite associée (32) avec chaque source de pression (28), la pression dans lesdits volumes à pomper étant progressivement réduite par l'établissement des communications fluidiques successives entre lesdits volumes à pomper et lesdites conduites associées (32).

5. Machine à carrousel selon la revendication 4, dans laquelle les mises en communication fluidique successives entre les volumes à pomper et les conduites associées (32) sont agencées pour que les pressions dans les volumes à pomper soient réduites en maintenant un écart inférieur à un seuil prédéterminé entre lesdites pressions.

6. Machine à carrousel selon la revendication 4 ou 5, dans laquelle le poste de traitement (4) comprend une enceinte (8) recevant le récipient (2) pris en charge par ledit poste de traitement (4), l'un des volumes à pomper étant formé par le volume interne du récipient (2) placé dans l'enceinte (8) et par le volume d'une conduite embarquée (10) s'étendant entre le volume interne et le raccord étanche tournant (14) et l'autre volume à pomper étant formé par le volume interne de l'enceinte (8) autour du récipient (2) placé dans l'enceinte (8) et par le volume d'une conduite embarquée (16) s'étendant entre le volume interne de l'enceinte (8) et le raccord étanche tournant (14).

7. Machine à carrousel selon l'une quelconque des revendications 1 à 6, dans laquelle la pluralité de sources de pression (28) comprend au moins un premier groupe de pompage (34) comprenant au moins une pompe et un deuxième groupe de pompage (36) comprenant au moins une pompe, le volume à pomper étant mis en communication fluidique avec le premier groupe de pompage (34) puis avec le deuxième groupe de pompage (36), la pompe du premier groupe de pompage (34) présentant un débit volumique inférieur au débit volumique de la pompe du deuxième groupe de pompage (36).

8. Machine à carrousel selon l'une quelconque des revendications 1 à 7, comprenant une pluralité de postes de traitement (4) comprenant chacun au moins un volume à pomper, lesdits volumes à pomper étant successivement mis en communication fluidique pendant une durée prédéterminée avec chaque source de pression (28) les uns après les autres.

9. Machine à carrousel selon l'une quelconque des revendications 1 à 8, dans laquelle le volume à pomper est mis simultanément en communication fluidique pendant un instant prédéterminé avec deux sources de pression (28), ledit instant prédéterminé étant inférieur à la durée prédéterminée inférieure ou égale au temps qu'une pression d'équilibre soit établie entre la pression dans ledit volume à pomper et la pression dans la conduite associée (32) à l'une des deux sources de pression (28).

10. Machine à carrousel selon l'une quelconque des revendications 1 à 9, dans laquelle au moins une des sources de pression (28) est associée à deux conduites associées (32) entre ladite source de pression (28) et le raccord étanche tournant (14), la pression dans lesdites conduites associées (32) étant différente l'une de l'autre avant la mise en communication fluidique de chacune desdites conduites associées (32) avec le volume à pomper.

11. Procédé d'établissement d'un vide dans un récipient à traiter au moyen d'une machine à carrousel (1) selon l'une quelconque des revendications 1 à 10, comprenant au moins les étapes suivantes :
- placer le récipient (2) dans un poste de traitement (4) de la machine à carrousel (1), le volume interne du récipient (2) et le volume d'une conduite embarquée (10) s'étendant entre le volume interne et le raccord étanche tournant (14) formant un volume à pomper dudit poste de traitement (4),
- placer ledit volume à pomper en communication fluidique avec une conduite associée (32) à une première source de pression (28) de la pluralité de sources de pression (28) pendant une première durée prédéterminée inférieure ou égale au temps qu'une pression d'équilibre soit établie entre la pression dans ledit volume à pomper et la pression dans ladite conduite associée (32), la pression dans le volume à pomper diminuant jusqu'à une première pression réduite pendant ladite première durée prédéterminée,
- placer le volume à pomper à la première pression réduite en communication fluidique avec une conduite associée (32) à une deuxième source de pression (28) de la pluralité de sources de pression (28) pendant une deuxième durée prédéterminée, la pression dans le volume à pomper diminuant de la première pression réduite à une deuxième pression réduite, inférieure à la première pression réduite pendant ladite deuxième durée prédéterminée.

12. Procédé d'établissement d'un vide selon la revendication 11, dans lequel la pression dans le volume à pomper est réduite jusqu'à une pression inférieure ou égale à 0.3 mbar en plaçant ledit volume à pomper successivement en communication fluidique avec au moins une conduite associée (32) à chaque source de pression (28) de la pluralité de sources de pression (28).

13. Procédé d'établissement d'un vide selon la revendication 11 ou 12, dans lequel le récipient (2) est placé dans une enceinte (8) du poste de traitement (4), le volume interne du récipient et le volume de la conduite embarquée (10) formant un premier volume à pomper dudit poste de traitement (4) et le volume interne de l'enceinte (8) autour du récipient (2) et le volume d'une conduite embarquée (16) s'étendant entre le volume interne de l'enceinte (8) et le raccord étanche tournant (14) formant un deuxième volume à pomper dudit poste de traitement (4), ledit deuxième volume à pomper étant mis en communication fluidique avec une source de pression (28) de la pluralité de sources de pression (28) avant ou simultanément avec le placement du premier volume à pomper en communication fluidique avec ladite source de pression (28).
